# EUROPÄISCHE PATENTANMELDUNG

(11) **EP 0 833 166 A2**
(43) Veröffentlichungstag der Anmeldung: **01.04.1998**
(21) Anmeldenummer: 97112011.8
(22) Anmeldetag: 15.07.1997
(51) Int. Cl.: G01R 31/06

(54) **Einrichtung zum Überprüfen der Funktion einzelner Magnete einer Elektromagnetanordnung**

(30) Priorität: 28.09.1996 DE 19640171
(71) Anmelder: H. Stoll GmbH & Co., D-72760 Reutlingen (DE)
(72) Erfinder: Ploppa, Jürgen, 72793 Pfullingen (DE); Daub, Ulrich, 72770 Reutlingen (DE); Buck, Manfred, 72768 Reutlingen (DE)
(74) Vertreter: Dreiss, Fuhlendorf, Steimle & Becker

(57) **Zusammenfassung**

Eine Einrichtung zum Überprüfen der Funktion einzelner Magnete einer Steuermagnetanordnung (10) für eine Mustervorrichtung an Strickmaschinen zur elektrisch gesteuerten Nadelauswahl ist mit mehreren jeweils mindestens eine ansteuerbare Steuerspule (52; 43, 53) aufweisenden Elektromagneten (29, 30) und mit einer Ansteuervorrichtung (86) für die Steuerspulen versehen. Um bei einer derartigen Einrichtung sowohl bei stehenden als auch bei bewegbaren Magnetanordnungen eine einfache Diagnose der qualitativen Funktion und ggf. der Funktionsabfolge der einzelnen Magnete der Elektromagnetanordnung bei reduziertem Hardwareaufwand zu erreichen sind eine den einzelnen Steuerspulen einer Gruppe von Magneten (29, 30; 40) der Elektromagnetanordnung (10) zugeordnete gemeinsame Diagnoseleitung (95) und eine mit der Diagnoseleitung (95) verbundene Auswerteeinheit (96) vorgesehen.

## Beschreibung

Die vorliegende Erfindung bezieht sich auf eine Einrichtung zum Überprüfen der Funktion einzelner Magnete einer Elektromagnetanordnung, beispielsweise einer Steuermagnetanordnung für eine Mustervorrichtung an Strickmaschinen zur elektrisch gesteuerten Nadelauswahl, nach dem Oberbegriff des Anspruchs 1.

Aus der DE 36 14 220 C1 ist eine Steuermagnetanordnung für eine Mustervorrichtung an Strickmaschinen zur elektrisch gesteuerten Nadelauswahl bekannt. Abgesehen davon, dass die Auswahlmagnete und die diesen zugeordneten Sensoren am hin- und her verfahrbaren Schlitten der Strickmaschine und die die Ansteuervorrichtungen enthaltenden Endstufen der einzelnen Auswahlmagnete ortsfest neben der Strickmaschine angeordnet sind, so dass eine erhebliche Vielzahl an Einzeladern innerhalb eines Schleppkabels hin und her verfahren werden müssen, ist weder die gewünschte Abfolge der Betätigung der Auswahlmagnete der Steuermagnetanordnung noch die Funktion der einzelnen Auswahlmagnete selbst weder quanitativ noch qualitativ in einfacher Weise nachvollziehbar bzw. überprüfbar. Die mangelnde quantitative Nachprüfbarkeit gilt aber auch bei solchen Magnetanordnungen, die an einer Maschine, einem Gerät o.dgl. ortsfest an einem unbewegbaren Teil angeordnet sind, wenn auch hier möglicherweise eine "sichtbare" Funktion aufgrund deren Bewegung erkennbar sein kann.

Aufgabe der vorliegenden Erfindung ist es deshalb, eine Einrichtung zum Überprüfen der Funktion einzelner Magnete einer Elektromagnetanordnung der eingangs genannten Art zu schaffen, mit der in einfacher Weise sowohl bei stehenden als auch bei bewegbaren Magnetanordnungen eine einfache Diagnose der qualitativen Funktion und ggf. der Funktionsabfolge der einzelnen Magnete der Elektromagnetanordnung bei reduziertem Hardwareaufwand möglich ist.

Zur Lösung dieser Aufgabe sind bei einer Einrichtung der genannten Art die im Anspruch 1 angegebenen Merkmale vorgesehen.

Durch die erfindungsgemäßen Maßnahmen ist es möglich, in einfacher Weise eine qualitative Überprüfung der Funktion zu erreichen, so daß sich eine Erhöhung der Betriebssicherheit ergibt, wobei der Hardwareaufwand reduziert ist. Dies macht außerdem die Durchführung von Servicearbeiten einfacher und schneller.

Gemäß einem bevorzugten Ausführungsbeispiel vorliegender Erfindung sind die Merkmale gemäß Anspruch 2 vorgesehen. Dadurch ist es möglich, die im Kabel zu führenden Einzelleitungen wesentlich zu reduzieren, was ebenfalls zur Betriebssicherheit beiträgt. Je nach Anzahl der Auswahlsysteme und der hardwaremäßigen Zusammenfassung der Vielzahl der Auswahlsysteme eines Schlittens einer Strickmaschine ist bezogen auf das einzelne Auswahlsystem eine weitere Reduzierung der Einzelleitung innerhalb eines Kabels möglich.

Sind in weiter bevorzugter Weise auch die Merkmale nach Anspruch 3 vorgesehen, ist auch die reine Funktion der einzelnen Magnete, die bisher schwer überprüfbar war, nunmehr in einfacher Weise nachzuvollziehen. Eine mögliche Fehlersuche bei der Inbetriebnahme wird vereinfacht, da es möglich ist, zunächst eine Diagnose über die gewünschte Abfolge der Tätigkeiten der Magnete zu erstellen.

Gemäß dem Merkmal des Anspruchs 4 kann eine quantitative bzw. Sichtkontrolle durch kostengünstige Leuchtdioden erfolgen. In einfacher Weise ist es für eine qualitative Kontrolle bzw. Diagnose möglich, die Merkmale gemäß Anspruch 5 vorzusehen.

Eine vorteilhafte Zusammenfassung der Möglichkeit der Überprüfung jeder einzelnen Steuerspule einer Gruppe von Magneten ist durch die Merkmale durch Anspruch 6 gewährleistet.

Für eine schnelle und einfache Auswertung der über die Diagnoseleitung ankommenden Daten sind die Merkmale gemäß Anspruch 7 vorgesehen.

Weitere vorteilhafte Ausgestaltungen ergeben sich durch die Merkmale einzelner oder mehrerer der Ansprüche 8 bis 11.

Gemäß einem weiteren bevorzugten Ausführungsbeispiel sind die Merkmale nach Anspruch 11 vorgesehen, wonach eine qualitative Auswertung innerhalb von Zeitfenstern erfolgt, die in vorteilhafter Weise aufgrund von Testuntersuchungen in verschiedenen Maschinenbereichen erstellt werden.

Weitere Einzelheiten der Erfindung sind der folgenden Beschreibung zu entnehmen, in der die Erfindung anhand der in der Zeichnung dargestellten Ausführungsbeispiele näher beschrieben und erläutert ist. Es zeigen:
- Figur 1: einen Längsschnitt durch ein Nadelbett einer Flachstrickmaschine und eine über diesem verfahrbar angeordnete Steuermagnetvorrichtung, die Teil einer Einrichtung zum Überprüfen der Funktion einzelner Magnete der Elektromagnetanordnung gemäß vorliegender Erfindung ist,
- Figur 2: in vergrößerter Darstellung einen Schnitt längs der Linie II-II der Figur 1, jedoch ohne Nadelbett,
- Figur 3: ein Blockschaltbild einer Einrichtung zum Überprüfen der Funktion einzelner Magnete der Steuermagnetanordnung nach den Figuren 1 und 2 gemäß einem Ausführungsbeispiel vorliegender Erfindung,
- Figur 4: ein Blockschaltbild einer Einrichtung zum Überprüfen der Funktion einzelner Magnete einer mit einer Vielzahl von Auswahlsystemen versehenen Steuermagnetanordnung gemäß einem weiteren Ausführungsbeispiel vorliegender Erfindung und
- Figur 5: ein auf einen Meßausgang bezogenes Impulsmeßdiagramm.

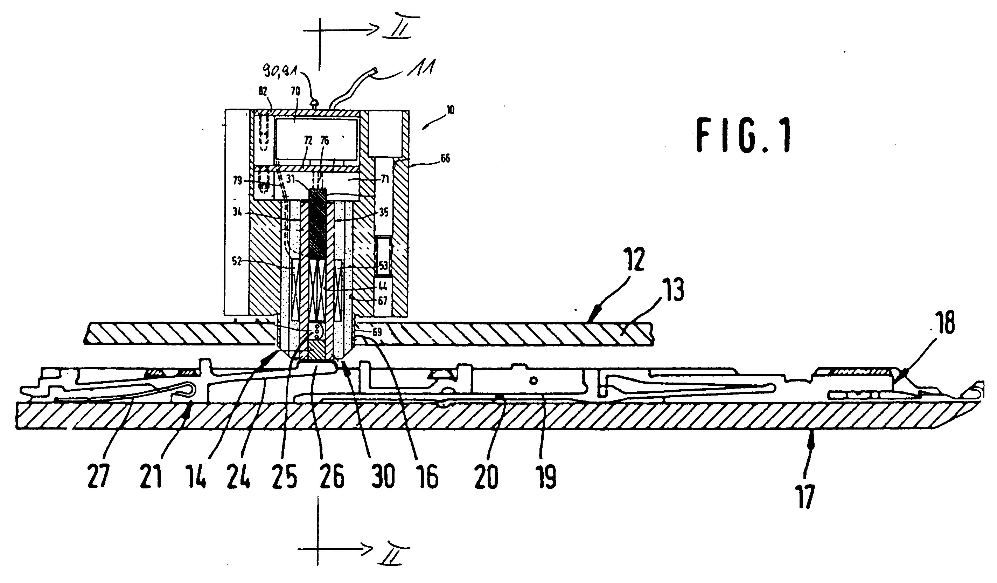

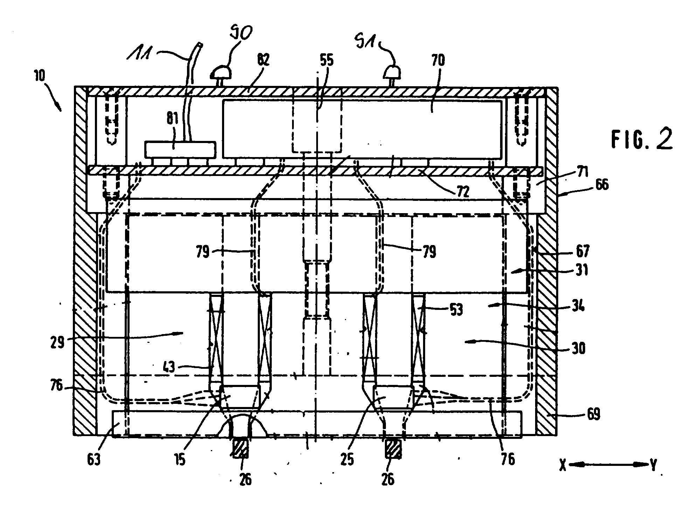

Bevor auf die erfindungsgemäße Einrichtung zum Überprüfen der Funktion einzelner Magnete einer Elektromagnetanordnung eingegangen wird, soll anhand der Figuren 1 und 2 als Beispiel für eine Elektromagnetanordnung eine Steuermagnetanordnung für eine Mustervorrichtung an Strickmaschinen zur elektrisch gesteuerten Nadelauswahl beschrieben werden. Es versteht sich, dass eine Elektromagnetanordnung, an der die Funktion einzelner Magnete überprüft werden soll, nicht nur eine derartige mit dem Schlitten hin- und herbewegbare Steuermagnetanordnung einer Strickmaschine sondern auch andere ortsfeste Elektromagnetanordnungen sein können.

Die Steuermagnetanordnung 10 gemäß den Figuren 1 und 2, die über ein Schleppkabel 11 mit einer nicht dargestellten Mustervorrichtung einer Flachstrickmaschine verbunden ist, ist auf der Rückseite einer Frontplatte 13 eines im einzelnen nicht dargestellten Schlittens 12 befestigt, wobei ein hier zwei Sensoren 15, 25 beinhaltendes Kopfteil 14 die Frontplatte 13 in einer schlitzförmigen Ausnehmung 16 durchdringt und die einem Nadelbett 17 gegenüberliegende Vorderseite der Frontplatte 13 überragt. Der mit der Steuermagnetanordnung 10 versehene Schlitten 12 ist längs des Nadelbetts 17 hin und her verfahrbar, in welchem in Nadelkanälen 20 eine Vielzahl von Stricknadeln 18 quer zur Schlittenlaufrichtung hin und her (in Figur 1 nach links und rechts) verfahrbar gelagert sind. Die Nadeln 18 sind in nicht näher beschriebener Weise mit einem Nadelstößer 19 verbunden, welcher von einer Auswahlplatine 21 beaufschlagbar ist. Die Auswahlplatine 21 ist im wesentlichen als zweiarmiger Hebel ausgebildet und im der betreffenden Stricknadel 18 zugeordneten Nadelkanal 20 in Bewegungsrichtung der Nadel 18 bewegbar gehalten; sie sitzt auf dem Grund des Nadelkanals 20 mittels einer Blattfeder 27 schwenkbar auf und besitzt an ihrem dem Nadelstößer 19 zugewandten vorderen Arm 24 ein Ankerteil 26 aus magnetischem Material.

In üblicher Weise werden beim Überfahren des Schlittens 12 die Auswahlplatinen 21 mittels am Schlitten 12 angeordneter nicht dargestellter Schlösser entgegen der Wirkung der Blattfeder 27 verschwenkt (entsprechend Figur 1) und damit der Steuermagnetanordnung 10 angeboten und von dieser in der angebotenen Stellung gehalten und bei weiterer Bewegung des Schlittens 12 entweder weiter gehalten oder durch Reduzierung der magnetischen Haltekraft auf Null losgelassen bzw. abgeworfen, so dass sich die betreffende Auswahlplatine 21 unter der Wirkung der Blattfeder 27 in ihre Ruhelage bewegen kann.

Beim dargestellten Ausführungsbeispiel besitzt die Steuermagnetanordnung 10 ein Auswahlsystem mit zwei hintereinander zur Wirkung kommenden Auswahlmagneten 29 und 30, denen ein leistenförmiger Permanentmagnet 31, der längsgerichtet hochkant verläuft und an dessen breiten Seitenflächen sich plattenförmig erstreckende Polschuhe 34, 35 anliegen, gemeinsam ist. Eine Aufteilung der Steuermagnetanordnung 10 in die beiden Auswahlmagnete 29 und 30 ergibt sich durch die in Figur 2 eingezeichnete Ebene 55. Die Polschuhe 34 und 35 sind in Längsrichtung gesehen in Haltepolschuh- und Steuerpolschuhelemente unterteilt. Die Steuerpolschuhelemente sind jeweils von einer Steuerspule 52 bzw. 43 und 53 umgeben, die mit ihrer Oberseite in einem geringen Abstand der unteren Längsseite des Permanentmagneten 31 gegenüberliegen und gleichsinnig gewickelt sind. Die in Figur 1 hinter der Steuerspule 53 liegende Steuerspule ist aus der Zeichnung nicht ersichtlich.

Im Kopfteil 14 der Steuermagnetanordnung 10 ist an der unteren Seite des entsprechenden Paares von Steuerspulen 52 bzw. 43, 53 und in einem Spalt 44 zwischen dem betreffenden beiden Steuerpolschuhelementen der Polschuhe 34 und 35 jedes Auswahlmagneten 29, 30 der Sensor 15 bzw. 25 zum Messen der magnetischen Feldstärke in jedem dieser Steuerpolbereiche angeordnet. Der Sensor 15, 25, für den beliebige die magnetische Feldstärke messende Elemente eingesetzt werden können, ist hier ein Hall-Generator. Längs einer an die Unterseite des Sensores 15, 25 unmittelbar angrenzenden Gleitleiste 63 können die Ankerteile 26 der Auswahlplatinen 21 entlang gleiten.

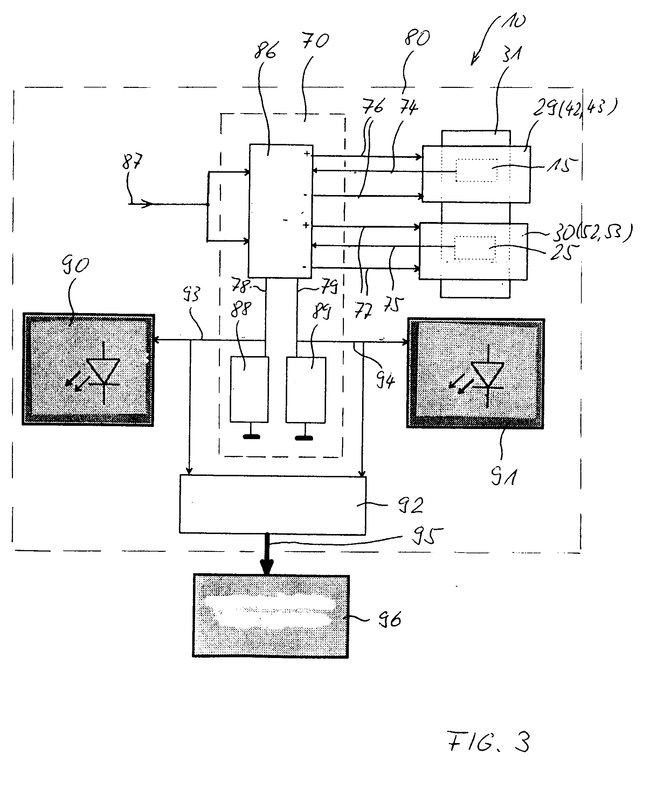

Die beiden ein Auswahlsystem bzw. eine -gruppe bildenden Auswahlmagnete 29 und 30 sind in einer rechteckförmigen Ausnehmung 67 eines Gehäuses 66 eingesetzt. An seiner offenen Vorderseite besitzt das Gehäuse 66 einen Ansatz 69, in welcher der Kopfteil 14 der beiden Auswahlmagnete 29 und 30 aufgenommen ist. Nach hinten schließt sich ein etwa rechteckförmiger Hohlraum 71 an, der durch eine lösbar befestigte Leiterplatte 72 unterteilt ist. Die Leiterplatte 72 bildet mit nicht dargestellten elektronischen Bauteilen eine Endstufe 86 für das Auswahlmagnetsystem 29, 30 und trägt jeweils einen jedem Steuerspulenpaar 43 bzw. 52, 53 zugeordneten Meßwiderstand 88, 89, welche Bauteile in Figur 3 in einen Kasten 70 zusammengefaßt und dort näher erläutert sind. Die Leiterplatte 72 trägt eine Steckerbuchse 81, in die das zu einer Auswerteeinheit 96 führende Kabel 11 für die hier dargestellten beiden Auswahlmagnete 29 und 30 einsteckbar ist. Der Hohlraum 71 ist von einem lösbar befestigten Deckel 82 abgedeckt. Das Gehäuse 66 ist an der Frontplatte 13 des Schloßschlittens 12 von außen lösbar befestigt, so dass es als ein die Auswahlmagnetgruppe bzw. Auswahlmagnete beinhaltendes Bauteil für sich austauschbar ist, ohne dass weitere Montagearbeiten vorgenommen werden müssen.

Figur 3 zeigt ein Ausführungsbeispiel einer Einrichtung zum Überprüfen der Funktion der Auswahlmagnete 29 und 30 der Steuermagnetanordnung 10. Die Endstufe 86 für die beiden Steuerspulenpaare 43 bzw. 52, 53 ist zusammen mit den beiden Meßwiderständen 88 und 89 im Kasten 70 und damit am hin und her bewegbaren Schlitten 12 gehalten. Die Endstufe 86 beinhaltet in nicht im einzelnen dargestellter Weise eine Ansteuerschaltung für die Steuerspulen 43 bzw. 52, 53, eine mit der Ansteuerschaltung verbundene Vergleicherschaltung, deren einer Eingang mit dem betreffenden Meßwiderstand 88, 89 und deren anderer Eingang mit einer ebenfalls Teil der Endstufe bildenden Steuerschaltung verbunden ist, die zur Verbindung mit dem Sensor 15 bzw. 25 ein Abgleichteil, ein einstellbaren Verstärker- und Pegelanpassungsteil und ein Schwellwert-Begrenzerteil aufweist. Als Verbindungsleitungen zwischen der Endstufe 86 und den Steuerspulen 43 bzw. 52, 53, dem Sensor 15 bzw. 25 und den Meßwiderständen 88, 89 sind interne Spannungsversorgungsleitungen 76, 77, eine Referenzspannungsleitung 74, 75 bzw. Meßleitungen 78, 79 vorgesehen. Zur Endstufe 86 führen Eingangsleitungen 87 zur mustergemäßen Ansteuerung und Spannungsversorgung jeder der Steuerspulen 43 bzw. 52, 53, welche Leitungen 87 als Bestandteil des Kabels 11 von einem Verteiler 92 des Schlittens 12 bzw. der Maschine zugeführt sind.

Soll ein angebotenes Ankerteil 26 einer Auswahlplatine 21 nach dem Entlanggleiten am Haltepolbereich eines Auswahlmagneten 29 oder 30 in dessen Steuerpolbereich abgeworfen werden, so wird mustergemäß dem betreffenden Steuerspulenpaar 43 bzw. 52, 53 ein Magnetisierungsstrom über die beiden Versorgungsleitungen zugeführt, derart, dass im Steuerpolbereich sehr schnell ein Magnetfeld aufgebaut wird, das dem Permanentmagnetfeld im Steuerpolbereich entgegengesetzt ist und gleiche Größe aufweist, so dass die magnetische Haltekraft auf einen bestimmen Wert reduziert wird, der kleiner als die Kraft der die Auswahlplatine 21 beaufschlagenden Blattfeder 27 ist. Vorzugsweise soll die magnetische Haltekraft zu Null werden.

Um diesen Wert der resultierenden magnetischen Haltekraft unabhängig davon, wie viele der dieser abzuwerfenden Auswahlplatine 21 vorauslaufenden Auswahlplatinen am nachfolgenden Haltepolbereich haften, genau zu erreichen, wird im Steuerpolbereich mittels des als Hall-Generator ausgebildeten Feldstärkesensors 15 bzw. 25 die dort momentan herrschende Feldstärke gemessen und in der Endstufe 86 verarbeitet wodurch die dem betreffenden Steuerspulenpaar zuzuführende und am Meßwiderstand 88, 89 abzugreifende optimale Magnetisierungsspannung bestimmt wird. Dabei erfolgt eine Ansteuerung des betreffenden Steuerspulenpaares nur dann, wenn über die Leitung von außen mustergemäß ein Ansteuersignal ankommt.

Zur Überprüfung bzw. Diagnose der mustergemäß zu erfolgenden Ansteuerung des bzw. der Steuerspulenpaare erfolgt sowohl eine optische als auch eine qualitative Kontrolle.

Zur optischen Kontrolle der Funktion der Steuerspulenpaare 52 bzw. 43, 53 wird die für die Endstufen-Verarbeitung am Meßwiderstand 88 bzw. 89 abgegriffene Magnetisierungsspannung über Leitungen 93, 94 auch einer optischen Kontrollvorrichtung 90 bzw. 91 zugeführt, die jeweils in Form einer einfachen Leuchtdiode ausgebildet sein kann. Beim dargestellten Ausführungsbeispiel ist diese Leuchtdiode 90 bzw. 91 von außen sichtbar am Gehäuse 66 angeordnet, wie dies schematisch aus Figur 2 hervorgeht. Damit ist eine optische quantitave Kontrolle dahingehend möglich, ob bzw. dass das betreffende Steuerspulenpaar eines Auswahlmagneten funktioniert bzw. angesteuert wird.

Der durch die Meßwiderstände 88, 89 fließende Magnetisierungsstrom verursacht eine proportionale Magnetisierungsspannung, welche über die Leitungen 93 und 94 dem Verteiler 92 zugeführt wird, in welchem die beiden Leitungen 93 und 94 hardwaremäßig zusammengefaßt sind. Wie aus Figur 3 anhand des Kastens 80 ersichtlich ist, sind auch diese Bauteile 90, 91 und 92 zusammen mit den Bauteilen des Kastens 70 am hin und her bewegbaren Schlitten 12 gehalten. Ausgangsseitig ist der Verteiler 92 mit einer Diagnoseleitung 95 verbunden, über welche die Magnetisierungsspannungen bzw. -ströme der beiden Steuerspulenpaare in analoger Weise und seriell der Auswerteeinheit 96, die außerhalb des Schlittens 12 bzw. der Maschine angeordnet ist, zugeführt werden. Die Ausgestaltung der Auswerteeinheit 96 wird nachfolgend anhand eines weiteren Ausführungsbeispieles beschrieben.

Auf diese Weise können bei dem bei diesem Ausführungsbeispiel mit zwei Steuerspulenpaaren 52 bzw. 43, 53 bzw. zwei Auswahlmagnete 29 und 30 versehenen Auswahlmagnetsystem der Steuermagnetanordnung 10 deren Funktion einerseits quantitativ, d.h. ob die Steuerspulen arbeiten oder nicht arbeiten und auch in der richtigen Reihenfolge arbeiten, durch visuelle Anzeiger, und andererseits qualitativ, d.h., ob die Steuerspulen mit der korrekten Magnetisierungsspannung beaufschlagt sind und daher richtig arbeiten, durch analoge Übertragung der Magnetisierungsspannungen bzw. -ströme zur Auswerteeinheit 96 erfasst und untersucht werden. Dabei reicht es aus, wenn das Kabel 11 für die beiden Steuerspulenpaare dieses einen Auswahlsystems drei Versorgungsleitungen, zwei Datenleitungen und eine Diagnoseleitung also insgesamt sechs Leitungen pro System beinhaltet.

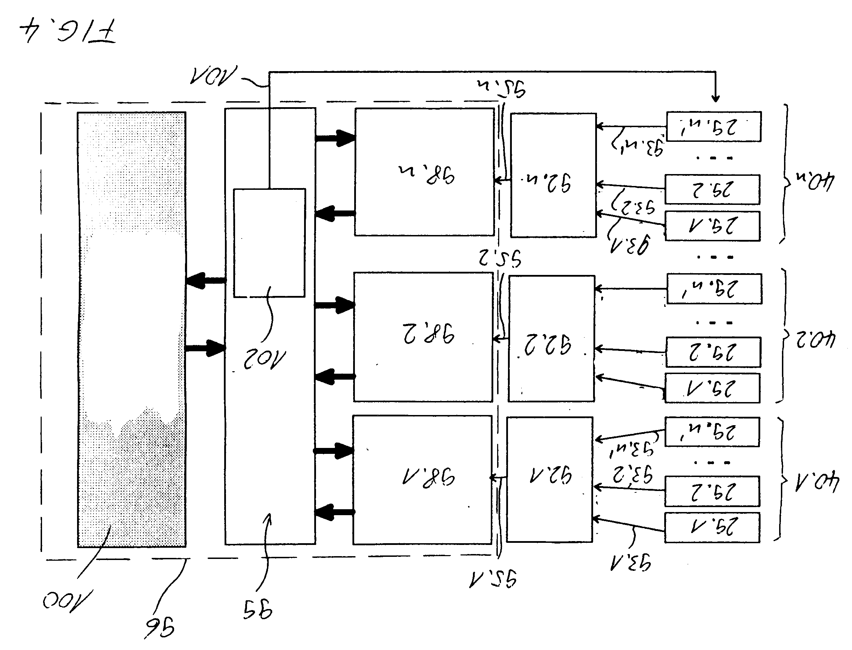

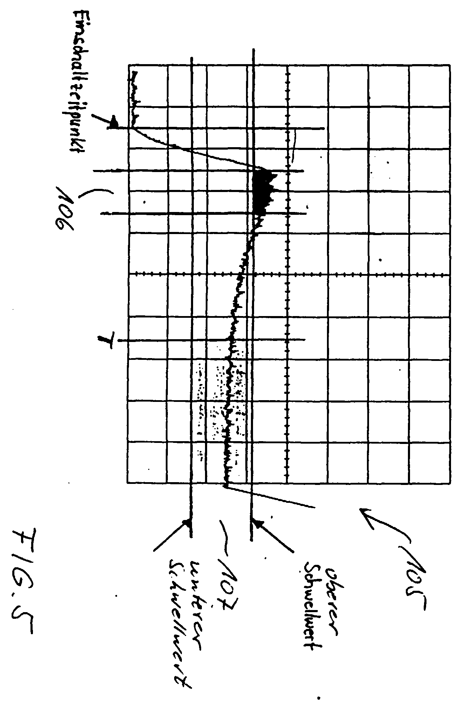

Anhand der Figuren 4 und 5 wird u.a. die qualitative Diagnose bzw. Auswertung der über die Diagnoseleitung 95 einkommenden Magnetisierungsspannungen der einzelnen Steuerspulenpaare beschrieben, wobei Figur 4 eine Einrichtung zeigt, die eine nahezu beliebige Vielzahl (n) von Auswahlmagnetsystemen bzw. -gruppen mit jeweils einer nahezu beliebige Vielzahl (n') von Auswahlmagneten bzw. Steuerspulenpaaren zugrunde legt.

Figur 4 zeigt n Auswahlmagnetsysteme bzw. -gruppen 40.1, 40.2....40.n, von denen jedes n' Auswahlmagnete 29.1, 29.2...29.n' aufweist. Dabei sind die jeweils n' Auswahlmagnete 29 eines Auswahlmagnetsystems 40 auf jeweils einem Schlittenteil gehalten. Die derzeit im Einsatz befindlichen größten Flachstrickmaschinen besitzen beispielsweise zwei Schlitten mit jeweils zwei Schlittenteilen und jeweils vier Auswahlmagneten. Alle Auswahlmagnete 29 jeweils eines Auswahlmagnetsystems 40 sind über eine Leitung 93.1, 93.2... bzw. 93.n' mit dem betreffenden Verteiler 92.1, 92.2... 92.n verbunden. Jeder Verteiler 92.1, 92.2... 92.n ist ausgangsseitig mit einer Diagnoseleitung 95.1, 95.2... 95.n verbunden, welche jeweils mit einem AD-Wandler 98.1, 98.2... 98.n zur Umwandlung der auf der Diagnoseleitung 95 ankommenden analogen Signale in digitale Signale verbunden ist. Die AD-Wandler 98 sind Teil der Auswertevorrichtung 96, die gleichzeitig einen Mikroprozessor 99 und einen Teil eines Leitrechners 100 beinhaltet. Der Mikroprozessor 99 ist mit jedem der AD-Wandler 89.1, 98.2... 98.n wechselweise verbunden und dient zur Koordination der n AD-Wandler 98 und der n Auswahlmagnetsysteme 40. Darüberhinaus besitzt hierzu der Mikroprozessor 99 eine Einheit 102, die zur seriellen Überprüfung bzw. Ansteuerung der n Auswahlmagnetsysteme 40 über eine Leitung 101 mit diesen verbunden ist. Der Mikroprozessor 99 erhält seine Daten zur testweisen oder betriebsweisen Ansteuerung der Auswahlmagnetsysteme 40 vom Leitrechner 100 und gibt die von den Auswahlsystemen empfangenen Daten zur Diagnose und qualitativen Auswertung an den Leitrechner 100.

Die Diagnose bzw. die qualitative Untersuchung der Funktion jedes der Auswahlmagnet 29 bzw. deren Steuerspulenpaare aller Auswahlmagnetsysteme 40 kann entweder vor Inbetriebnahme der Maschine während eines Testprogramms oder während des Betriebs außerhalb des Arbeitsbereichs am Nadelbett erfolgen. Dazu werden die einzelnen Auswahlmagnete 40 bzw. deren Steuerspulenpaare über die Leitung 101 seriell angesteuert, indem die betreffenden Endstufen 86 beaufschlagt werden, über die ein Magnetisierungsstrom durch die betreffenden Steuerspulenpaare der Auswahlmagnete 40 geschickt wird. In pro serieller Weise werden die analogen Magnetisierungsspannungen über die Verteiler 92 und dann seriell über die Diagnoseleitungen 95 zum betreffenden AD-Wandler 98 und von dort in digitaler Weise über den Mikroprozessor 99 zum Leitrechner 100 geführt. Die serielle Ansteuerung der Steuerspulenpaare der Auswahlmagnete 29 erfolgt in einer zuvor durch eine optische Kontrolle bestimmte Aufeinanderfolge bzw. Sequenz der Funktion der einzelnen Steuerspulenpaare. Diese dort festgelegte Sequenz wird im Testverfahren bei der Inbetriebnahme oder während des Betriebs eingehalten.

Die qualitative Untersuchung der Magnetisierungsströme der einzelnen Auswahlmagnete 29 bzw. deren Steuerspulenpaare erfolgt anhand einer in Figur 5 dargestellten Fensteranordnung 105, innerhalb deren vorgegebenen Zeitfenstern 106 und 107 bestimmte Zeitbereiche des Magnetisierungsstromes liegen müssen, ansonsten eine genaue Funktion des betreffenden Auswahlmagneten 29 nicht gewährleistet ist. Wenn auch im Leitrechner 100 diese qualitative Untersuchung anhand des digitalisierten Magnetisierungsstrombildes durchgeführt wird, sei der Übersichtlichkeit wegen die Grundlage dieser Überprüfung in Figur 5 anhand eines analogen Schaubildes beschrieben. Die in Figur 5 dargestellten Zeitfenster 106 und 107 sind das Ergebnis einer Reihe von Funktionsmessungen und damit das Ergebnis von Erfahrungswerten. Es versteht sich, dass die Lage der Fenster 106 und 107 sich je nach Anzahl der nebeneinander liegenden Steuerspulenpaare und abhängig vom Ort längs der Flachstrickmaschine unterschiedlich sein kann. Dies kann jedoch im Programm des Leitrechners 100 berücksichtig sein. Das erste Fenster 106 liegt in einem bestimmten Zeitbereich nach dem Einschaltzeitpunkt des Auswahlimpulses und oberhalb eines Schwellenwertes. Endet die Anstiegsflanke des Auswahlimpulses in diesem ersten Fenster 106, heißt dies, dass der Anstiegsstrom einen Schwellenwert nach einem bestimmten Zeitbereich überschritten hat, und somit die Magnetisierungsstromanstiegszeit in Ordnung ist. Das zweite Fenster 107 beginnt in einer bestimmten Zeit T nach Ende des ersten Fensters und liegt zwischen dem oberen Schwellenwert, d.h. einer oberen Grenze für den Magnetisierungs- bzw. Kompensationsstrom und einer unteren Grenze für diesen Strom. Der Magnetisierungsstrom ist dann zur Kompensation des permanenten Magnetfeldes in richtiger Weise geeignet, wenn der Arbeitsanteil des Magnetisierungsstromes innerhalb des zweiten Fensters 107 liegt.

Es versteht sich, dass der Leitrechner 100 nicht nur die Programmdaten für die Abfolgetestphase und die qualitative Testphase der Auswahlsysteme bzw. deren Steuerspulenpaare liefert, sondern auch für eine mustergemäße Ansteuerung der Flachstrickmaschine während des Arbeitsbetriebes sorgt.

Wie bereits eingangs erwähnt, kann mit Hilfe der erfindungsgemäßen Einrichtung nicht nur eine gemäß der Zeichnung beschriebene bewegbare Steuermagnetanordnung sondern auch eine ortsfeste Elektromagnetanordnung anderer Maschinen, Geräte u.dgl. quantitativ und qualitativ untersucht, bewertet und diagnostiziert werden.

## Patentansprüche

1. Einrichtung zum Überprüfen der Funktion einzelner Magnete einer Elektromagnetanordnung, beispielsweise einer Steuermagnetanordnung (10) für eine Mustervorrichtung an Strickmaschinen zur elektrisch gesteuerten Nadelauswahl, mit mehreren jeweils mindestens eine ansteuerbare Steuerspule (52; 43, 53) aufweisenden Elektromagneten (29, 30) und mit einer Ansteuervorrichtung (86) für die Steuerspulen, **gekennzeichnet durch** eine den einzelnen Steuerspulen einer Gruppe von Magneten (29, 30; 40) der Elektromagnetanordnung (10) zugeordneten gemeinsamen Diagnoseleitung (95) und durch eine mit der Diagnoseleitung (95) verbundene Auswerteeinheit (96).

2. Einrichtung nach Anspruch 1, dadurch gekennzeichnet, dass die Ansteuervorrichtung (86) der verfahrbaren Elektromagnetanordnung (10) räumlich zugeordnet und die Diagnoseleitung (95) nach außerhalb der verfahrbaren Elektromagnetanordnung (10) geführt ist.

3. Einrichtung nach Anspruch 1 oder 2, dadurch gekennzeichnet, dass der verfahrbaren Elektromagnetanordnung eine Kontrollvorrichtung (90, 91) räumlich zugeordnet ist.

4. Einrichtung nach Anspruch 3, dadurch gekennzeichnet, dass die Kontrollvorrichtung (90, 91) durch optische Elemente, vorzugsweise Leuchtdioden gebildet ist.

5. Einrichtung nach mindestens einem der Ansprüche 1 bis 4, dadurch gekennzeichnet, dass die Auswerteeinheit (96) durch einen Mikroprozessor (99) gebildet ist.

6. Einrichtung nach mindestens einem der vorhergehenden Ansprüche, dadurch gekennzeichnet, dass jede Steuerspule einer Gruppe von Magneten (40) über eine Einzeldiagnoseleitung (93) mit einem der Magnetgruppe (40) gemeinsamen Verteiler (92) verbunden ist, dessen Ausgang durch die Diagnoseleitung (95) gebildet ist.

7. Einrichtung nach den Ansprüchen 5 und 6, dadurch gekennzeichnet, dass zwischen dem Mikroprozessor (99) und dem Verteiler (92) ein AD-Wandler (98) vorgesehen ist.

8. Einrichtung nach Anspruch 5, dadurch gekennzeichnet, dass die Auswerteeinheit (96) einen Mikroprozessor (99) zur Koordination der Magnetgruppen (40) aufweist.

9. Einrichtung nach den Ansprüchen 5 und 7, dadurch gekennzeichnet, dass die Auswerteeinheit (96) einen Mikroprozessor zur Koordination der AD-Wandler (98) aufweist.

10. Einrichtung nach den Ansprüchen 8 und 9, dadurch gekennzeichnet, dass der Mikroprozessor (99) zur seriellen Überprüfung der Magnetgruppen (40) mit diesen verbunden ist.

11. Einrichtung nach mindestens einem der vorhergehenden Ansprüche, dadurch gekennzeichnet, dass über die Diagnoseleitung (95) eine Magnetisierungsspannung, welche proportional dem bei einem Auswahlimpuls durch die betreffende Steuerspule fließenden Magnetisierungsstromes ist, einem Mikroprozessor (99) der Auswerteeinheit (96) zugeführt und dort ausgewertet wird.

12. Einrichtung nach Anspruch 11, dadurch gekennzeichnet, dass als Maß für die Auswertung ein erstes Zeitfenster (106), in dem der Magnetisierungsstrom nach dem Zuschalten des Auswahlimpulses einen Schwellenwert überschritten haben muß, und ein zweites Zeitfenster (107), innerhalb dem der Arbeitsstrom liegen muß, verwendet ist.
